Europäisches Patentamt

European Patent Office

Office européen des brevets

(19)

(11) Numéro de publication: **0 020 999**
**B1**

(12)

# FASCICULE DE BREVET EUROPEEN

(45) Date de publication du fascicule du brevet: **13.04.83**

(51) Int. Cl.³: **G 11 C 29/00**

(21) Numéro de dépôt: **80102658.4**

(22) Date de dépôt: **13.05.80**

(54) **Procédé de mesure du temps d'accès d'adresse de mémoires, mettant en oeuvre la technique de recirculation des données, et testeur en résultant.**

(30) Priorité: **29.06.79 FR 7917303**

(43) Date de publication de la demande:
**07.01.81 Bulletin 81/1**

(45) Mention de la délivrance du brevet:
**13.04.83 Bulletin 83/15**

(84) Etats contractants désignés:
**DE FR GB**

(56) Documents cités:
**COMPUTER DESIGN, vol. 15, no. 5, mai 1976 Winchester US H. DE JONGE et al.: "Moving inversions test pattern is thorough, yet speedy", pages 169—173**

(73) Titulaire: **International Business Machines Corporation**
**Armonk, N.Y. 10504 (US)**
(84) **DE GB**
(73) Titulaire: **Compagnie IBM FRANCE**
**5 Place Vendôme**
**F-75000 Paris 1er (FR)**
(84) **FR**

(72) Inventeur: **Jocotton, Jacky Henri**
**11 Square A. d'Aubigné**
**F-91100 Saint Germain les Corbeil (FR)**
Inventeur: **Vanoudheusden, Bernard**
**30 rue de l'Abbaye**
**F-91610 Ballancourt (FR)**

(74) Mandataire: **Klein, Daniel**
**COMPAGNIE IBM FRANCE Département de Propriété Industrielle**
**F-06610 La Gaude (FR)**

Courier Press, Leamington Spa, England.

## 0 020 999

Procédé de mesure du temps d'accès d'adresse de mémoires mettant en oeuvre la technique de recirculation des donnés, et testeur en résultant

### Domaine technique

La présente invention concerne le test des mémoires. Elle concerne plus particulièrement un procédé de mesure du temps d'accès d'adresse de mémoires (RAM ou ROS), mettant en oeuvre la technique de recirculation des données et son application à un testeur.

### Etat de la technique

Le temps d'accès d'adresse (AAT ou address access time selon la terminologie anglo-saxonne) est une mesure importante de la qualité des mémoires, car il mesure la rapidité de réponse de la mémoire. De façon classique, ce temps est mesuré de la façon suivante: admettons que le contenu de la mémoire à tester correspondant à une adresse $A_0$ soit disponible sur les lignes de sorties de donnees, au temps t=0, l'adresse est changée, l'adresse $A_1$ est introduite dans la mémoire. L'AAT est le temps mis par les nouvelles données pour apparaître sur les lignes de sortie.

Il est reconnu que les mesures de l'AAT nécessitent la mise en forme et la calibration de signaux très rapides (temps inférieur à 2 ns), des temps de cycle de 5 à 100ns, des temps de décalage entre les niveaux des lignes d'adresse inférieurs à 0,1ns, et des résolutions avec des incréments inférieurs à 0,1ns. La réalisation de circuits aussi performants, notamment de générateurs de mots hautes fréquences (>100 MHz) conduit à des testeurs sophistiqués et coûteux.

L'article "Moving inversions test pattern is thorough, yet speedy" de H. de Jonge et al paru dans Computer Design, vol 15 n° 5, Mai 1976, p, 169—173, propose une série de tests dynamiques pour mesurer l'AAT. Cependant, ces tests sont basés sur un programme informatique qui change séquentiellement les valeurs des adresses, créant ainsi un AAT à chaque saut d'une adresse à une autre, et non pas sur la technique de recirculation des données, qui caractérisé la présente invention.

### Exposé de l'invention

L'objet de l'invention consiste en un procédé pour l'application des techniques de recirculation au test des mémoires (RAM ou ROS), pour la mesure de l'AAT. L'invention propose en outre un testeur à recirculation, mettant en oeuvre ledit procédé et capable d'être charge manuellement ou automatiquement, simple et économique.

La présente invention concerne un procédé de mesure du temps d'accès d'adresse (AAT) d'une mémoire du genre comportant une ligne de sélection lecture/écriture, une pluralité de lignes de sortie de données, une pluralité de lignes d'entrée de données, et une pluralité de lignes d'adresse, caractérisé par la recirculation des données entre n lignes de sortie de données et n lignes d'adresse et en ce qu'il comporte les étapes suivantes:

— mise de la ligne de sélection sur la position écriture,
— chargement dans la mémoire d'une configuration désirée de $2^n$ mots de n bits correspondant aux $2^n$ adresses: toutes les adresses sont balayèes et à chaque adresse (k) on écrit le mot: [mot (k)],
— mise de la ligne de sélection sur la position lecture,
— connexion de n lignes de sortie de données à n lignes d'adresse par n lignes à retard de délai $\tau$; puisqu'il y a un maximum de $m=2^n$ différents mots, il existe un entier $p\leq m$ tel que

$$k=[mot (mot (\ldots mot (k))\ldots)]$$

en fait p mots, de telle sorte que la mémoire oscille avec une fréquence F telle que

$$F=\frac{1}{p(\tau+AAT)}$$

AAT représentant une approximation moyenne des AAT correspondant à toutes les combinaisons des adresses intervenant dans la recirculation,

— mesure de la fréquence F et détermination du paramètre p et,
— détermination de la valeur de l'AAT par la relation AAT

$$=\frac{1}{pF}-\tau$$

Elle concerne également un testeur pour la mesure automatique des AAT des mémoires du type comportant une ligne de sélection lecture/écriture, une pluralité de lignes d'entrée et de sortie de

2

données et une pluralité de lignes d'addresse, pour la mise en oeuvre dudit procédé et caractérisé en ce qu'il comporte:

— des moyens pour charger la mémoire selon une configuration désirée contenue dans une mémoire annexe, afin que pour chaque adresse (k) on écrive un mot [mot (k)] pendant que la ligne de sélection se trouve en position écriture,
— des moyens pour connecter n lignes de sortie de données de la mémoire à n lignes d'adresse à travers n lignes à retard de délai $\tau$, pour la faire recirculer entre ces adresses pendant que la ligne de sélection se trouve en position lecture, de telle sorte que la mémoire oscille avec une fréquence F telle que

$$F=\frac{1}{p(\tau+AAT)}$$

— des moyens de synchronisation de ces opérations associés à des moyens d'initialisation et de blocage des séquences de chargement et de recirculation et,
— des moyens de mesure de la fréquence F. L'invention est exposée ci-après plus en détail à l'aide de dessins présentant plusieurs modes de réalisations.

Brève description des figures

La figure 1 permet de comprendre la définition du temps d'accès d'adresse (AAT), qui est l'intervalle de temps mesuré entre l'introduction d'une nouvelle adresse dans la mémoire et le moment où le contenu de la mémoire pour cette adresse, est disponible sur les lignes de sortie de données.

La figure 2 représente une mémoire en cours de test avec une boucle de recirculation des données entre la ligne de sortie de données d.O1 et la ligne d'adresse ad $2^0$.

La figure 3 représente les signaux d'oscillation décalés dans le temps sur la ligne de données d.O1 et la ligne d'adresse ad $2^0$, quand il y a une boucle de recirculation.

La figure 4 représente une mémoire en cours de test identique à celle de la figure 2 avec quatre boucles de recirculation.

La figure 5 représente le diagramme des différents cas de recirculation possible, soit entre plus de deux adresses, soit entre deux adresses, soit enfin un système stable.

La figure 6 représente la réalisation pratique du test de la mémoire de la figure 2 dans laquelle les étapes de chargement et de recirculation sont entièrement manuelles.

La figure 7 représente une autre réalisation pratique du test de la mémoire de la figure 2 dans laquelle les étapes de chargement et de recirculation sont automatiques.

La figure 8 représente le diagramme des niveaux de tension correspondant aux lignes de sélection lecture/écriture R/W, d'entrée de données d.il, d'adresse ad $2^0$ et du relai pour le test précédent.

La figure 9 représente un circuit spécialisé pour le test automatique de la mémoire montrée sur la figure 2.

La figure 10 représente une mémoire de 32×3 en cours de test dont les résultats seront détaillés ci-après.

Les figures 11 et 12 représentent respectivement les courbes de détermination de l'AAT pour un échantillon de mémoires de 32×3 pour des recirculations entre deux adresses successives.

La figure 13 représente les AAT mesurés pour toutes les combinaisons de deux adresses différentes pour une mémoire de 32×3.

Description de l'invention

I. Principe de la technique de recirculation appliquée à la mesure de l'AAT des mémoires

a) Principe de la mesure de l'AAT entre deux adresses

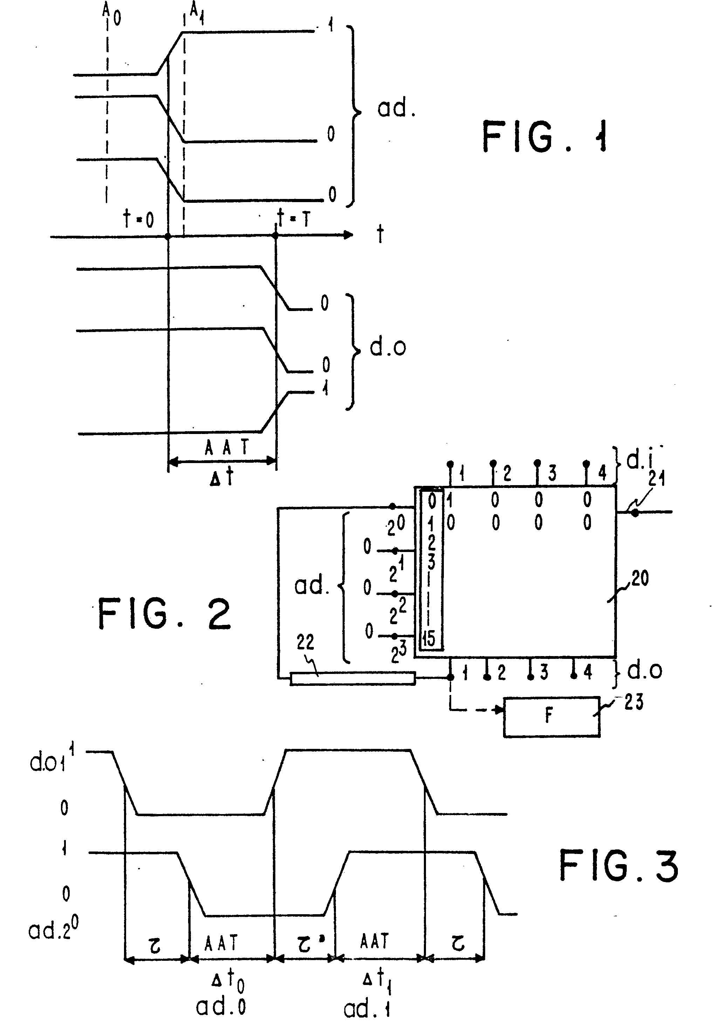

La figure 1 permet de comprendre la définition de l'AAT pour une mémoire présentant trois lignes d'adresse (ad) et trois lignes de sortie de données (d.O). Le contenu de l'adresse $A_0$ (011) est dans la mémoire, le mot (110) est disponible sur les lignes de données de sortie. Au temps t=0, l'adresse est changée, la nouvelle adresse $A_1$ (100) est introduite dans la mémoire. Les nouvelles données correspondant à cette adresse (001) sont disponibles au bout d'un temps $\Delta t$ sur les lignes de sortie de données. Le temps $\Delta t$ mesure le temps d'accès d'adresse ou AAT.

L'AAT est le temps le plus critique dans la mémoire car c'est lui qui limite le temps de cycle.

Sur la figure 2 on a représenté schématiquement une mémoire classique 20 munie de quatre lignes d'adresses $2^0$ à $2^3$ (soit 16 adresses différentes de 0 à 15) et de quatre lignes de données de sortie d.21 à d.O4. Elle est munie de façon classique d'une ligne de sélection R/W 21 qui selon son niveau de tension permet de choisir entre les modes d'écriture et de lecture. Elle comporte également un décodeur d'adresses non représenté. Supposons que l'on veuille effectuer une opération de recirculation entre les adresses 0 et 1. On force un "0" logique sur les lignes d'adresse $2^1$, $2^2$, et $2^3$. On

écrit "1" dans is bit de poids 1 (ligne d'il) à l'adresse 0 et "0" dans le bit de poids 1 (ligne d'il) à l'adresse 1. Ce qui revient à écrire 0001 et 0000 aux adresses 0 et 1, grâce aux lignes d'entrée de données d.il à d.i4. Puis on connecte la ligne de sortie de données d.01 à la ligne d'adresse ad $2^0$ à travers une ligne à retard 22 de délai $\tau$.

Supposons que la mémoire soit alors à l'adresse 1, au temps t:0 apparaîtra en sortie le mot (0000), c'est-à-dire qu'on aura 0 sur d.01.

Au temps t=$\tau$ l'adresse sera égale à 0 sur la ligne $2^0$; lorsqu'on affiche une adresse sur une mémoire, il lui faut le temps AAT pour donner le mot correspondant (1000), donc au temps t=AAT+$\tau$ le mot (1000) apparaît en sortie, l'itération est la suivante:

| | Signal sur la ligne d'adresse $2^0$ | Signal sur la ligne de donnée d.01 |
|---|---|---|
| t=0 | 1 | 0 |
| t=$\tau$ | 0 | 0 |
| . t=$\tau$+AAT | 0 | 1 |
| t=($\tau$+AAT)+$\tau$ | 1 | 1 |
| . t=($\tau$+AAT)+($\tau$+AAT) | 1 | 0 |
| t=2($\tau$+AAT)+$\tau$ | 0 | 0 |
| . t=2($\tau$+AAT)+$\tau$+AAT | 0 | 1 |
| t=3($\tau$+AAT)+$\tau$ | 1 | 1 |
| . | | |
| . | | |
| . | | |

Cette itération peut être présentée différemment. On peut raisonner en termes d'adresses et de mots apparaissant sur les lignes de sortie de données, sachant qu'à l'adresse k on a écrit le mot: [mot (k)]

| délais | adresse | mots (sortie d.O) |
|---|---|---|
| t=0 | 0001 | mot (0001)=0000 |
| t=$\tau$+AAT | mot (0001)=0000 | mot (mot (0001))=0001 |
| t=2($\tau$+AAT) | mot (mot (0001))=0001 | mot (mot (mot (0001)))=0000 |

Comme on le voit d'après ces itérations la mémoire oscille avec une période T=2 ($\tau$+AAT). Cette période apparaît également sur la figure 3, qui représente les signaux apparaissant sur les lignes d.01 et ad $2^0$.

Le facteur $\tau$ dépend de la ligne à retard 22 qui est un composant passif, c'est donc un temps parfaitement déterminé, et indéréglable. C'est une caractéristique propre au testeur.

La mesure de F=1/T avec un fréquencemètre 23 ou à partir de toute autre technique permet de connaître l'AAT pour cette ligne d'adresse.

En fait l'AAT que l'on mesure est une approximation des différents AAT pour chaque adresse, car on mesure successivement l'intervalle de temps $\Delta t$ qui sépare le temps que mettent les données pour sortir quand on passe de l'adresse 0 à l'adresse 1 puis l'intervelle de temps $\Delta t$ que mettent les données pour sortir quand on passe de l'adresse 1 à l'adresse 0. En fait $\Delta t_1 \neq \Delta t_2$ et on peut raisonnablement écrire $\Delta t_1 = \Delta t_2$ =AAT pour simplifier.

b) Principe de la mesure de l'AAT moyen pour plusieurs adresses

Il peut être intéressant de faire osciller la mémoire sur plus de deux adresses, ce qui donne la possibilité de moyenner une pluralité d'AAT et de fournir des indications plus précises sur la rapidité de la mémoire. Egalement cette approche peut être utile dans le cas de configurations critiques: par exemple quand il y a beaucoup de lignes d'adresse à commuter simultanément.

On considère que l'on veut recirculer entre n lignes de sortie de données et n lignes d'adresses (ce qui correspond à $2^n$ adresses).

On place la ligne de sélection lecture/écriture en position écriture.

On charge un mot de n bits dans chacune des m=$2^n$ adresses, an d'autres termes, on balaye toutes les adresses et dans chaque adresse k ($0<k<2^{n-1}$) on écrit un mot [mot (k)]

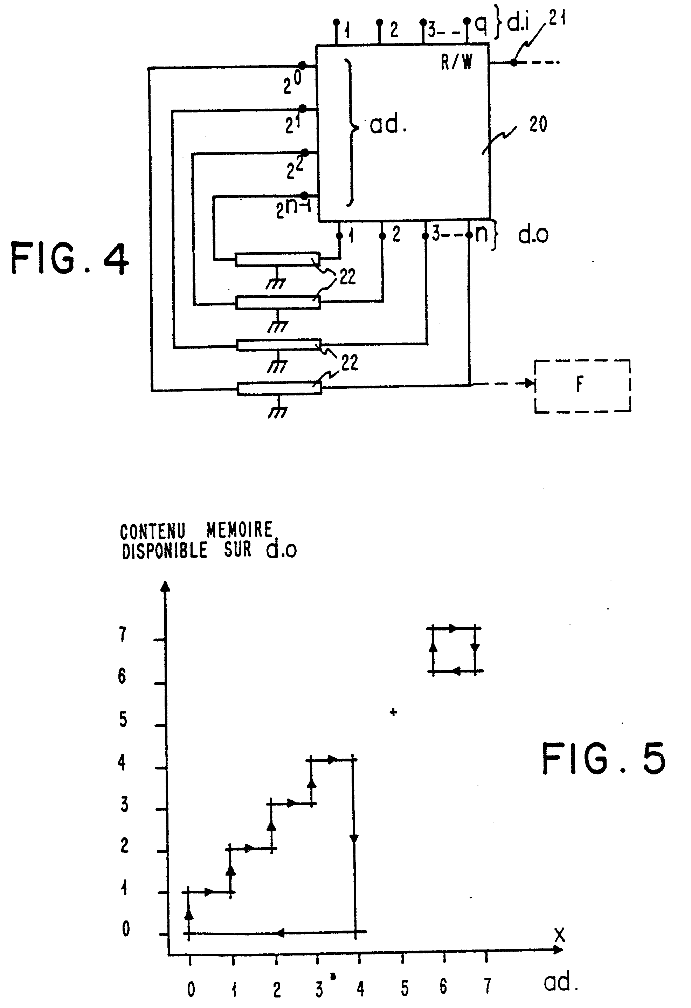

On reboucle les n lignes de sortie avec les n lignes d'adresses à travers n lignes à retard 22 (de délai unitaire $\tau$) comme cela est représenté schématiquement sur la figure 4. On positionne la mémoire 20 en mode lecture grâce à la ligne de sélection R/W 21.

Supposons que la mémoire soit à l'adresse (1). Au temps t=0, apparaîtra en sortie le mot [mot (1)], à t=$\tau$ l'adresse sera égale à [mot (1)], mais il faut un temps $\Delta t$=AAT entre le moment où cette adresse est affichée et le moment où le mot correspondant à cette adresse est disponible sur les lignes de sortie de données:

aussi au temps $t=(\tau+AAT)$        apparaîtra en sortie [mot (mot (1))]

au temps $t=(\tau+AAT)+\tau$        apparaîtra l'adresse [mot (mot (1))]

au temps $t=2\,(\tau+AAT)$        apparaîtra en sortie [mot (mot (mot (1)))]

.
.
.

au temps $t=j\,(\tau+AAT)$        apparaîtra en sortie [mot (... (mot (1)) ...)]

En fait (j+1) mots, comme il n'y a au maximum que $m=2^n$ mots différents, il existe le nombre entier $p \leq m$, tel que au bout de p adresses balayées, le cycle recommence, c'est-à-dire que l'on peut écrire:

$$k=\underbrace{[\text{mot} (...(\text{mot} (k)) ...)]}_{p \text{ mots}}$$

En d'autres termes le mot disponible sur les lignes de sortie correspond en fait à une adresse déja traitée, ce qui assure la recirculation, en raisonnant comme ci-dessus en termes d'adresse et de mots on a avec p mots la correspondance suivante:

| Délai | Adresse | Mots (sortie d.O) | |
|---|---|---|---|
| $t=0$ | k | [mot (k)] | |
| $t=\tau+AAT$ | [mot (k)] | [mot (mot (k))] | |
| | . | . | P fois |
| | . | | |
| | . | | |
| $t=(p-1)\,(\tau+AAT)$ | $\underbrace{[\text{mot} (... (\text{mot} (k)) ...)]}_{(p-1)\text{mots}}$ | $\underbrace{[\text{mot} (... (\text{mot} (k)) ...)]}_{p \text{ mots}}$ | |
| $t=p(\tau+AAT)$ | k | | |

car par hypothèse

$$k=\underbrace{[\text{mot} (... (\text{mot} (k)) ...)]}_{p \text{ mots}}$$

On peut conclure que la mémoire va osciller à une fréquence

$$F=\frac{1}{p(\tau+AAT)}$$

Dans le cas précédent, la figure 3 avait mis en évidence que p=2. De façon générale ce facteur p est facilement déterminé par la séquence qui a été préalablement chargée.

Par extension de ce qui avait été écrit alors, l'AAT mesuré ici correspond à une moyenne des différents AAT pris en compte lors des différentes combinaisons d'adresse, une explication plus détaillée sera donnée lors de l'étude de la figure 13.

Ce facteur p est tel que $2 \leq p \leq 2^n$ dépend des mots chargés dans la mémoire, tandis que comme on l'a vu $\tau$ est une constante. La mesure de la fréquence peut se faire avec un fréquencemètre 23.

c) Illustration

Ces considérations théoriques correspondent à différents fonctionnements possibles et vont être explicitées ci-après dans le cas d'une mémoire RAM comprenant huit mots de trois bits, c'est-à-dire avec trois lignes d'adresse et trois lignes de sortie de données.

Le contenu de la mémoire est donné dans le tableau I. Pour chacune des adresses, le mot de trois bits en binaire a été remplacé directement par l'adresse qui lui correspond. Par exemple l'adresse 0 correspond en fait à 000, et si le contenu du mot à l'adresse 4 est 000 on écrira que le contenu est 0.

TABLEAU I

| adresse | 0 | 1 | 2 | 3 | 4 | 5 | 6 | 7 |
|---------|---|---|---|---|---|---|---|---|
| contenu | 1 | 2 | 3 | 4 | 0 | 5 | 7 | 6 |

En partant de cette table on obtient de diagramme de la figure 5. On a représenté respectivement sur l'axe des x les adresses (numérotées de 0 à 7) et sur l'axe des y les contenu de la mémoire à l'adresse correspondants qui sera après le délai $\tau$ appliquée au décodeur d'adresse pour fournir la nouvelle adresse.

Supposons que la première adresse décodée soit 0, pour cette adresse le contenu de la mémoire est 1. Après un temps $\tau$+AAT, 1 sera la nouvelle adresse décodée. Le nombre 2 contenu à l'adresse 1 sera transféré au décodeur après un temps $\tau$+AAT et ainsi de suite. On peut suivre la séquence sur la figure 5, qui se poursuit jusqu'à ce que l'adresse 0 soit de nouveau retrouvée (ici à l'adresse 4), la mémoire va alors osciller selon le cycle d'adresse 0—1—2—3—4—0 ... etc.

Il en sera de même dans le cas où la première adresse décodée sera l'une des adresses 1, 2, 3 ou 4.

Par contre, si la première adresse décodée est 5, le contenu correspondant est 5 et après le délai $\tau$+AAT, 5 sera la nouvelle adresse décodée. La mémoire restera sur cette adresse, le système sera stable (voir figure 5).

Si nous supposons maintenant que la première adresse décodée est 6, la donnée de sortie correspondant à cette adresse est 7, ce 7 est transféré après un temps $\tau$+AAT comme nouvelle adresse; à cette adresse correspond le contenu 6. Dans ce dernier cas comme cela apparaît sur la figure 5, la mémoire oscille entre les adresses 6 et 7.

Ainsi, on peut confirmer les différents modes de fonctionnement étudiés ci-dessus aux points Ia et Ib. Il y a donc trois fonctionnements envisageables:—

— la recirculation entre deux adresses,
— la recirculation le long d'un cycle comportant plusieurs adresses,
— et le système stable.

Le mode de fonctionnement dépendant seulement de l'adresse choisie pour initialiser l'opération et du contenu (choisi généralement) de la mémoire.

Des impulsions erratiques (bruit) pourraient faire basculer d'un mode de fonctionnement à un autre mode non désiré. Il est donc souhaitable de choisir une configuration de données qui ne laisse qu'un mode possible. Si l'on veut circuler entre deux adresses seulement, les adresses 0 et 2 par exemple, on choisira les données représentée sur le tableau II.

TABLEAU II

| adresse | 0 | 1 | 2 | 3 | 4 | 5 | 6 | 7 |
|---------|---|---|---|---|---|---|---|---|
| contenu | 2 | 0 | 0 | 0 | 0 | 0 | 0 | 0 |

Le seul mode de fonctionnement possible est entre les adresses 2 et 0. Toutes les autres adresses renvoient à 0, assurant ainsi le cycle 2←—→0.

II. Mode de réalisation préféré

Ainsi qu'on vient de le voir, le chargement de la mémoire et la connexion ultérieure des lignes de sorties de données et des lignes d'adresse représentent deux points clés de l'invention.

Il y a deux façons de procéder:

a) Chargement manuel.

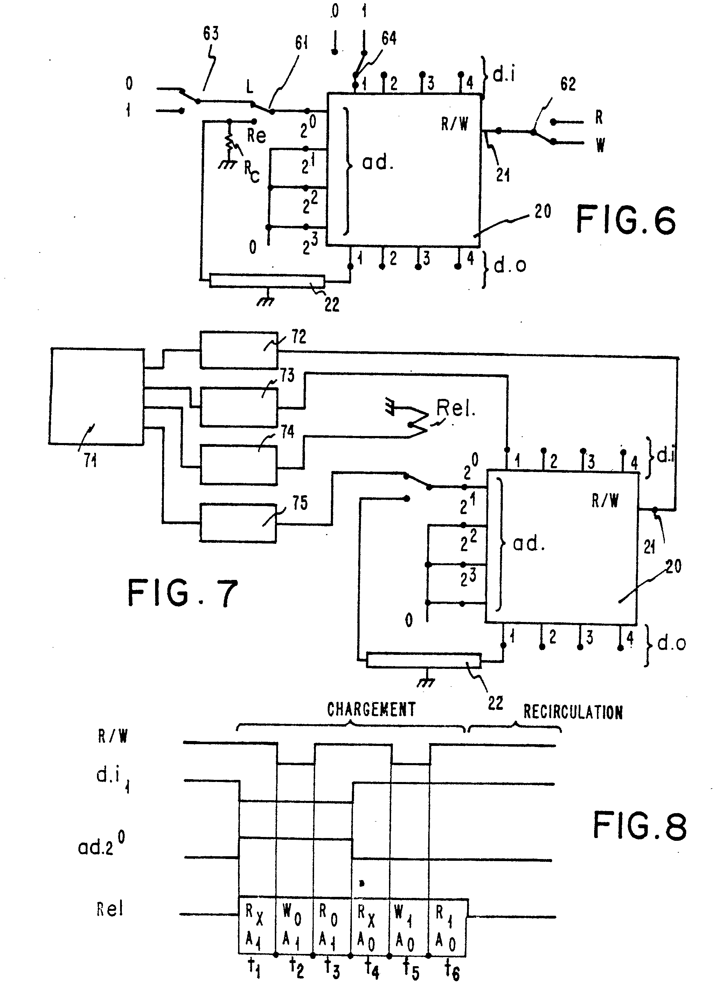

Le circuit est représenté sur la figure 6. La mémoire est chargée grâce à plusieurs commutateurs qui sont opérés manuellement.

Chargement: Le commutateur 61 est en position L (charge), le commutateur 62 qui commande le niveau de la ligne de sélection écriture/lecture 21 est en position W (écriture), le commutateur 63 est en position "adresse 0" et le commutateur 64 est en position "écrire 1". C'est la disposition des commutateurs représentée sur la figure 6. Le nombre 1 est ainsi placé à l'adresse 0. Puis en disposant le commutateur 63 sur la position 1, et le commutateur 64 sur la position 0, on introduit un 0 l'adresse 1.

Recirculation: le commutateur numéro 62 est mis en position R (lecture), et le commutateur 61 en position Re (recirculation).

La mémoire oscille donc entre les adresses 0 et 1 et on peut mesurer avec un fréquencemètre (non représenté) la fréquence d'oscillation et en déduire la valeur de l'AAT. La ligne à retard 22 est fermée sur l'impédance caractéristique Rc de la ligne; la valeur de Rc est imposée par les spécifications de la mémoire à tester. La ligne à retard a un délai $\tau$, qui est spécifié par le constructeur et qui est fonction de la longueur de cette ligne.

Ce système présente les advantages du coût et de la simplicité, cependant il est très lent (30 secondes sont nécessaires pour charger la mémoire), et nécessite en outre la présence permanente d'un opérateur).

b) Chargement automatique

Une première solution est représentée sur la figure 7. Ce système comprend un générateur de mots 71 programmable fonctionnant comme générateur d'impulsions et quatre circuits de mise en forme 72 à 75. Le circuit 74 commande un relai Rel. qui permet de relier la ligne d'adresse ad $2^0$ à la ligne à retard pendant l'opération de lecture. Les commutateurs de sélection R/W 62 et d'entrée de données 64 (figure 6) ne sont plus nécessaires.

Un cycle de fonctionnement commandé par le générateur 71 est montré sur la figure 8.

Sur cette figure, on a représenté les niveaux de tension des différentes lignes, de sélection lecture/écriture R/W, d'entrée de données d.il, d'adresse ad $2^0$ et l'état du relai Rel. Le relai est au niveau 1 (excité) pendant l'étape de chargement (c'est la position représentée sur la figure 7). Pendant cette étape, on écrit 0 à l'adresse 1 pendant le temps t2; le 0 est lu pendant le temps t3; puis on écrit un 1 à l'adresse 0 pendant le temps t5, opération qui est vérifiée pendant le temps t6. Ensuite, le relais passe au niveau 0 et on fait recirculer les données.

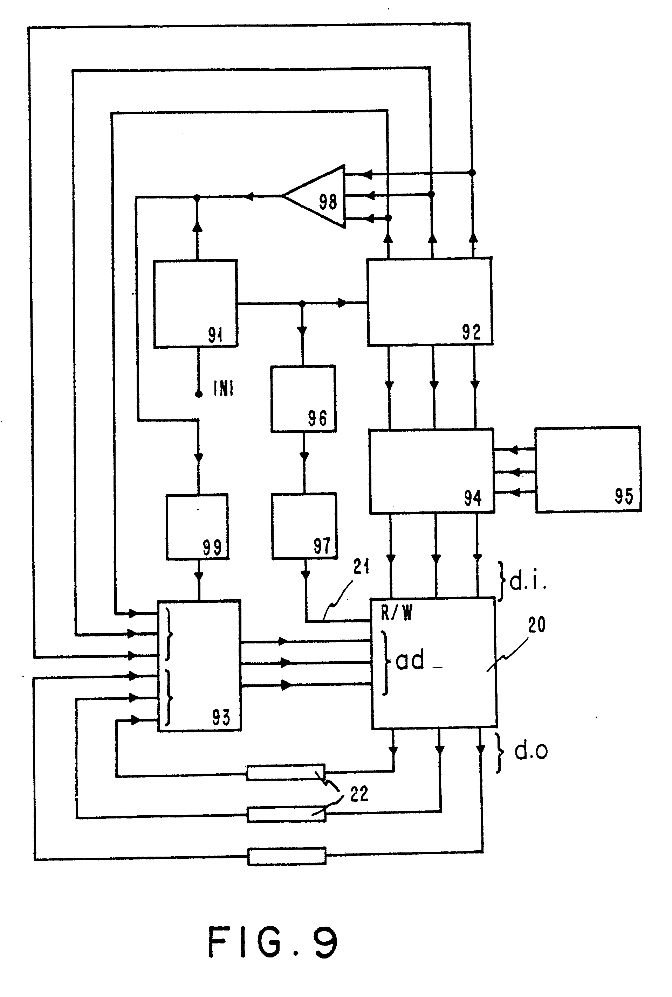

Une deuxième solution consistait à réaliser un circuit spécifique pour assurer le chargement, et la recirculation pour permettre les mesures de l'AAT d'une mémoire. Le système complet est représenté sur la figure 9. Dans le test par recirculation, la séquence est chargée dans la mémoire par un circuit spécialisé, qui joue donc le rôle classique du générateur de mots, mais en plus simple et en moins rapide (fréquence d'horloge 1 MHz, et calage des signaux avec une précision inférieure à 50 nanosecondes), puisque comme on l'a vu, l'AAT est essentiellement fonction du délai de la ligne à retard. En outre, tout le circuit spécialisé qui est réalisé en logique TTL standard peut tenir, sur une seule carte, ce qui permet de faire des économies considérables sur le testeur.

Chargement: Dans un premier temps les adresses sont balayées tandis que l'on charge dans chacune d'elles sont contenu. L'horloge 91 incrémente un compteur binaire 92. D'une part, les signaux issus de ce compteur 92 incrémentent le multiplexeur 93 qui pilots les circuits d'adresse de la mémoire 20 en cours de test et d'autre part, simultanément, servent de commande pour le multiplexeur 94 qui balaie le contenu de la matrice de programmation 95 (qui contient les informations à écrire dans la mémoire). Cette matrice peut être une mémoire de type ROM, ou REPROM, ou un simple panneau de commande avec commutateur.

Le circuit de retard 96 permet de compenser les détais dûs au compteur 92 et aux multiplexeurs 93 et 94 (pour être certain que les adresses et les données arrivent en synchronisme sur la mémoire) et d'appliquer à la ligne R/W 21 le potentiel d'écriture pendant le temps approprié. Le circuit de génération d'impulsions d'écriture 97 permet de positionner la mémoire en position d'écriture sous la commande du circuit 96. Lorsque toutes les adresses ont été balayées, le circuit ET 98 détecte la dernière adresse (par exemple 111) appliquée à la mémoire, et vient bloquer les impulsions d'horloge et après un certain délai dans le circuit 99 vient faire basculer le multiplexeur 93 de manière à boucler les sorties de la mémoire sur les adresses correspondantes afin de la faire recirculer.

Ce circuit permet d'automatiser la mesure. Il suffit d'une impulsion (manuelle ou télécommandée) sur le circuit de remise à zéro de l'horloge, pour déclencher la recirculation.

Pour assurer un test significatif, il est important que les données introduites en mémoire ne puissent subir les modifications non désirées au cours du temps. En d'autres termes le contenu des cellules de mémoire doit être stable. D'où l'utilisation d'alimentations en puissance programmable à faible bruit, le contrôle des températures, le contrôle des cellules de mémoire non concernées par le test, qui pourront néanmoins être chargées.

Les mesures de fréquences sont réalisées avec un compteur numérique. Dans les résultats qui vont suivre on a utilisé une ligne à retard de 4,7 nanosecondes, pour des mémoires qui ont des AAT moyens de l'ordre de 5 nanosecondes. La fréquence correspondante est

$$F = \frac{1}{2(AAT+\tau)} = 50 \text{ MHz.}$$

III. Résultats

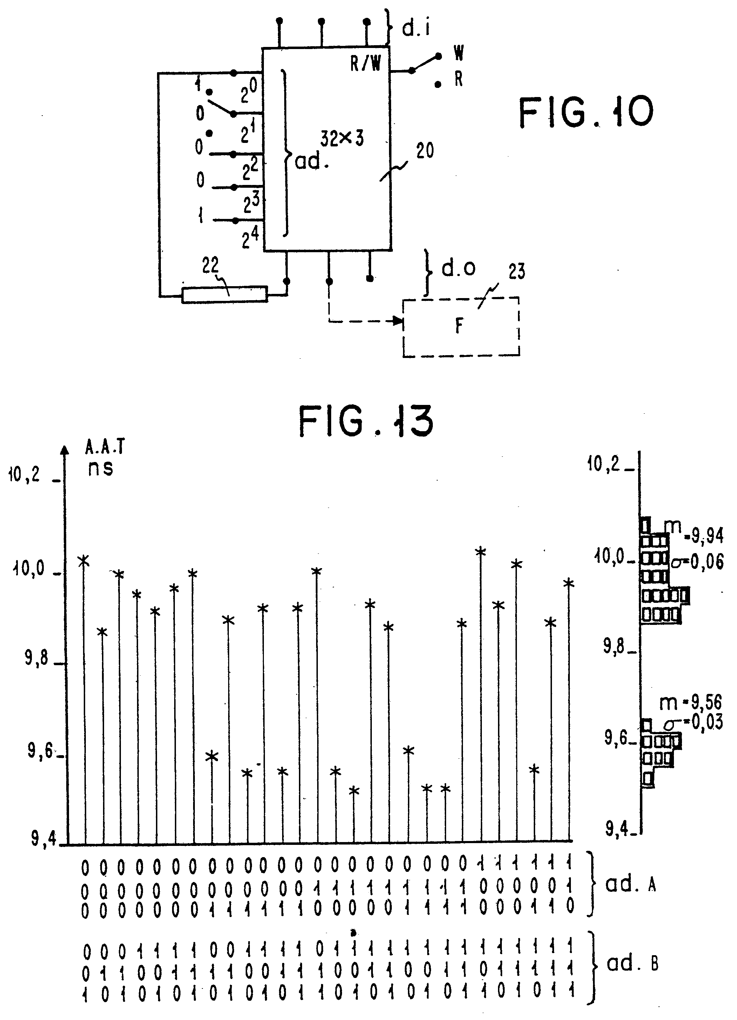

Un montage expérimental montré sur la figure 10 voisin de celui montré sur la figure 2, a été réalisé pour tester une mémoire 32×3 (32 mots de 3 bits). On assure la recirculation entre deux lignes d'adresse consécutives à deux emplacements différents de la mémoire, par exemple entre les adresses 16 et 17 d'une part et 18 et 19 d'autre part. Dans le premier cas, à l'adresse 16 (10000), on a chargé 17 (10001) et à l'adresse 17 (10001) on a chargé 16 (10000). On a procédé de façon similaire pour, les adresses 18 et 19, à l'adresse 18 on a chargé 19 et à l'adresse 19 on à chargé 18. En ce qui concerne les autres lignes d'adresse on applique un 1 à la ligne d'adresse $2^4$ et 0 aux lignes d'adresses $2^3$ et $2^2$. Une ligne à retard de 4,7 nanosecondes assure le rebouclage sur la ligne d'adresse ad $2^0$.

On a disposé un commutateur sur la ligne d'adresse ad $2^1$ qui permet d'appliquer des valeurs binaires 0 et 1. Quand le commutateur est sur la position 1, on recircule entre les adresses 18 et 19 et quand il est sur la position 0, on recircule entre les adresses 16 et 17. Un fréquencemètre est disposé sur d.02 afin de ne pas perturber les mesures. On va donc mesurer la somme des temps d'accès d'adresse correspondant aux adresses 16 et 17 d'une part et 18 et 19 d'autre part.

Les résultats ont été comparés aux temps mesurés par un testeur plus performant de type classique sur un échantillon de 100 mémoires.

$$F = \frac{1}{2(AAT+\tau)} \quad \text{d'où} \quad ATT = \frac{1}{2F} - \tau$$

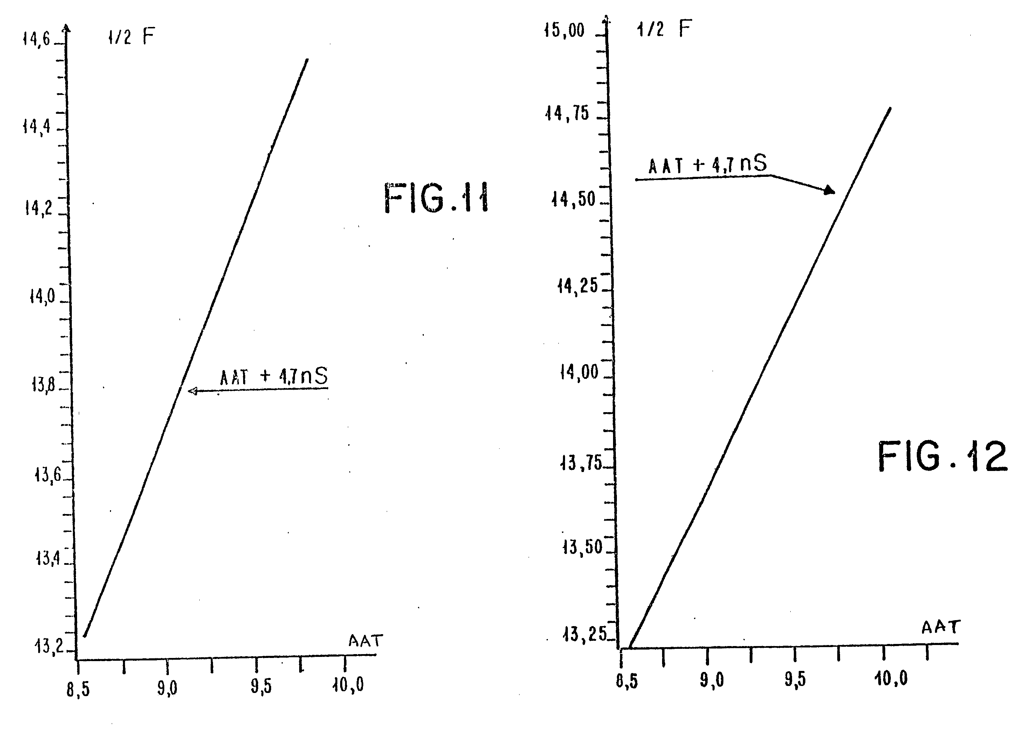

On a corrélé les AAT mesurés sur le testeur classique avec 1/2F. Les résultats sont montrés sur la figure 11 pour la recirculation entre les adresses 16 et 17 et sur la figure 12 pour la recirculation entre les adresses 18 et 19. Ils mettent respectivement en évidence les éléments suivants:

(adresses 16, 17)—Le facteur de corrélation entre AAT et 1/2F est de 0,92.

La valeur de la différence moyenne:

$$\frac{1}{2F} - AAT$$

est de 4,7 secondes, c'est le délai de la ligne à retard et

La déviation standard résiduelle est de 95 picosecondes.

Pour les adresses (18, 19), le facteur de corrélation entre AAT et 1/2F est de 0,92.

La valeur de la différence moyenne:

$$\frac{1}{2F} - AAT$$

est 4,5 nanosecondes.

La déviation standard résiduelle est de 95 picosecondes.

La technique de recirculation permet des mesures de temps d'accès d'adresses avec une précision égale ou supérieurs à celle des appareils classiques les plus performants à ce jour.

On a enfin comparé les AAT résultants de différentes combinaisons d'adresses. On a mesuré les AAT pour une recirculation entre deux adresses de l'adresse A ($0 \le A \le 7$) à l'adresse B ($0 \le B \le 7$) pour chaque couple A,B ($A \ne B$) et qui correspond à 28 couples.

On peut voir sur la figure 13 pour chaque couple (A,B) en abscisse, on a représenté la somme des AAT correspondant à ce couple, c'est-à-dire ($AAT_{(A \to B)} + AAT_{(B \to A)}$) en ordonnées. On peut se rendre compte que lorsque les adresses A et B ont au moins deux bits opposés, l'AAT est d'environ 400 picosecondes à 500 picosecondes plus rapide, par exemple pour le couple adA=010 et adB=101 l'AAT correspondant est d'environ 9,5 nanosecondes. On a représenté sur la figure, les moyennes et les écarts types.

IV. Application industrielle

La technique de test par recirculation permet le test AC (en courant alternatif) des mémoires RAM et ROS, en ce qui concerne l'AAT. Ce test est effectué avec une grande précision de mesure et est très économique car la circuiterie est simple et peu performante (au point de vue des fréquences). En plus elle est indépendante de la vitesse de la mémoire à tester. Les résultats obtenus montrent que les mesures de fréquence peuvent être effectuées facilement avec des résolutions de $10^{-4}$ soit sur un temps de 30ns, une résolution de 3ps. La résolution sera d'autant meilleure que la mémoire sera plus rapide.

Cependant elle est limitée par le choix des configurations de test pour éviter les impulsions de bruit comme on l'a vu et également dans le test des mémoires ROS qui ont un contenu préalablement déterminé.

**Revendications**

1. Procédé de mesure du temps d'accés, d'adresse (AAT) d'une mémoire comportant une ligne de sélection lecture/écriture une pluralité de lignes de sorties de données une pluralité de lignés d'entrée de données et une pluralité de' lignes d'adresse caractérisé par la recirculation des données entre n lignes de sortie de données (d.O) et n lignes d'adresse (ad.) et en ce qu'il comporte les étapes suivantes:

— mise de la ligne de sélection sur la position écriture,
— chargement dans la mémoire d'une configuration désirée de $2^n$ mots de n bits correspondant aux $2^n$ adresses: toutes les adresses sont balayées et à chaque adresse (k) on écrit un mot [mot (k)],
— mise de la ligne de sélection sur la position lecture,
— connexion de n lignes de sortie de données (d.O) à n lignes d'adresses (ad.) par n lignes à retard (22) délai $\tau$; puisqu'il y a un maximum de $m=2^n$ différents mots, il existe un entier $p \leq m$ tel que

$$k = [\text{mot} (\text{mot} (\ldots \text{mot} (k) \ldots)]$$

en fait p mots, de telle sorte que la mémoire oscille avec une fréquence F telle que

$$F = \frac{1}{p(\tau + AAT)}$$

le terms AAT représentant une approximation moyenne des AAT correspondant à toutes les combinaisons des adresses intervenant dans la recirculation,

— mesure de la fréquence F et détermination du paramètre p et,
— la revendication n° 3 est supprimée conformément à la lettre de la demanderesse reçue le 16.0182 détermination de la valeur de l'AAT par la relation

$$AAT = \frac{1}{pF} - \tau$$

2. Procédé selon la revendication 1 caractérisé en ce que ladite configuration de mot est telle que si à l'adresse k on écrit le mot [mot (k)] et à l'adresse j on écrit le [mot (j)] on ait [mot (k)]=adresse j et [mot (j)]=adresse k, de telle sorte que l'on recircule entre les deux adresses k et j, d'où l'on déduit

$$AAT = \frac{AAT_{k \to j} + AAT_{j \to k}}{2}.$$

3. Procédé selon la revendication 1 ou 2, caractérisé en ce que la mémoire est une mémoire de type RAM.
4. Testeur pour la mesure automatique des AAT des mémoires du type comportant une ligne de sélection lecture/écriture, une pluralité de lignes d'entrée et de sortie de données et une pluralité de lignes d'adresse, pour la mise en oeuvre du procédé selon la revendication no 1, caractérisé en ce qu'il comporte:

— des moyens (91—94) pour charger la mémoire (20) selon une configuration désirée contenue dans une mémoire (95) annexe, afin que pour chaque adresse (k) on écrive un mot [mot (k)] pendant que la ligne de sélection se trouve en position écriture,
— des moyens pour connecter n lignes de sortie de données de la mémoire à n lignes d'adresse à travers n lignes (22) à retard de délai $\tau$, pour la faire recirculer entre ces adresses pendant que la ligne de sélection se trouve en position lecture, de telle sorte que la mémoire oscille avec une fréquence F telle que

$$F = \frac{1}{p(\tau + AAT)},$$

— des moyens de synchronisation de ces opérations associés à des moyens d'initialisation et de blocage des séquences de chargement et de recirculation et,
— des moyens de mesure de la fréquence F.

5. Testeur selon la revendication 4 caractérisé en ce que lesdits moyens de chargement comprennent un multiplexeur (94) relié d'une part aux lignes entrée de données de la mémoire et d'autre part à la mémoire annexe (95) qui contient la configuration de mots désirée sous la commande d'un compteur (92) contrôlé par les moyens de synchronisation des séquences (91).
6. Testeur selon la revendication 5 caractérisé en ce que lesdits moyens de recirculation comprennent un multiplexeur (93) alimentant les lignes d'adresse qui reçoit d'une part les données du compteur (92) et d'autre part, les données provenant des lignes de sortie de la mémoire à travers les lignes à retard, la commutation entre ces données s'effectuant sous la contrôle des moyens de synchronisation.

7. Testeur selon la revendication 6 caractérisé en ce que lesdits moyens de synchronisation (91) sont constitué par une horloge, ils sont associés à des moyens de blocage (98) quand toutes les adresses ont été balayées et à des moyens d'initialisation (INI) pour démarrer la séquence de mesure.

8. Testeur selon la revendication 7 caractérisé en ce que la ligne de sélection écriture/lecture est commandée par les moyens de sélection contrôlés par les moyens de synchronisation.

9. Testeur selon la revendication 7 ou 8 caractérisé en ce que lesdits moyens de sélection comportent un circuit de délai (96) et un générateur d'impulsions (97).

10. Testeur selon la revendication 9 caractérisé en ce que la commutation des données dans le multiplexeur (93) est contrôlée par un circuit de retard (99).

**Patentansprüche**

1. Messverfahren zum Messen der Adressenzugriffszeit (AAT) eines Speichers mit einer Schreib/Leseauswahlleitung, mehreren Datenausgangsleitungen, mehreren Dateneingangsleitungen und mehreren Adressenleitungen, dadurch gekennzeichnet, daß Daten zwischen n Datenausgangsleitungen (do) und n Adressenleitungen (ad) wieder in Umlauf gesetzt werden, und daß es folgende Schritte einschließt:

— Positionieren der Auswahlleitung auf der Schreibposition,
— Laden in den Speicher einer gewünschten Konfiguration von $2^n$ Wörtern mit je n Bits, die den $2^n$ Adressen entsprechen, wobei alle Adressen abgetastet werden und ein Wort [Wort (k)] in jede Adresse (k) geschrieben wird,
— Positionieren der Auswahlleitung auf der Leseposition,
— Anschluß der n Datenausgangsleitungen (do) an die n Adressenleitungen (ad) über n $\tau$-Verzögerungsleitungen (22); da das Maximum $m=2^n$ verschiedene Wörter beträgt, hat man eine ganze Zahl $p \leq m$, und daher

$$k=[Wort (Wort (\ldots Wort (k) \ldots))]$$

d.h., p Wörter, so daß der Speicher mit einer Frequenz F schwingt, und daher

$$F = \frac{1}{p\,(\tau + AAT)}$$

wobei der Term AAT allen in dem Wiederumlauf vorkommenden Adressenkombinationen entspricht,
— Messen der Frequenz F und Bestimmen des Parameters p, und
— Bestimmen des ATT-Wertes durch die Beziehung

$$ATT = \frac{1}{pF} - \tau.$$

2. Verfahren nach Anspruch 1, dadurch gekennzeichnet, daß die Wörterkonfiguration dergestalt ist, daß wenn das Wort [Wort (k)] in die Adresse k, und das Wort [Wort (k)] in die Adresse j geschrieben wird, man [Wort (k)]=Adresse j und (Wort (j)=Adresse k erhält, so daß zwischen den beiden Adressen ein Wiederumlauf stattfindet, woraus man folgert,

$$ATT = \frac{ATTk{-}j + ATTj{-}k}{2}$$

3. Verfahren nach Anspruch 1 oder 2, dadurch gekennzeichnet, daß der Speicher ein Speicher vom Typ RAM ist.

4. Prüfgerät zum automatischen Messen des ATTs der Speicher mit einer Schreib/Leseleitung, mehreren Dateneingangs- und Datenausgangsleitungen und mehreren Adressenleitungen zum Ausführen des Verfahrens nach Anspruch 1, dadurch gekennzeichnet, daß es einschließt:

— Lademittel (91—94) zum Laden des Speichers (20) gemäß einer gewünschten, in dem Hilfsspeicher (95) enthaltenen Konfiguration, so daß für jede Adresse (k) ein Wort [Wort (k)] geschrieben wird, während sich die Auswahlleitung auf der Schreibposition befindet,

10

— Wiederumlaufmittel zum Anschluß von n Datenausgangsleitungen des Speichers an n Adressenleitungen über n $\tau$-Verzögerungsleitungen (22) zum Wiederumlauf zwischen diesen Adressen während sich die Auswahlleitung auf der Leseposition befindet, so daß der Speicher mit einer Frequenz F schwingt, und daher

$$F = \frac{1}{p\,(\tau + AAT)}$$

— Synchronisiermittel zum Synchronisieren dieser Operationen, die den Initialisier- und Blockiermitteln für die Lade- und Wiederumlauffolgen zugeordnet sind, und
— Messmittel zum Messen der Frequenz F.

5. Prüfgerät nach Anspruch 1, dadurch gekennzeichnet, daß diese Lademittel einen Multiplexer (94) einschließen, der einerseits an die Dateneingangsleitungen des Speichers und anererseits an den Hilfsspeicher (95) angeschlossen ist, der die gewünschte Wortkonfiguration enthält, und der unter der Kontrolle eines Zählers (92) steht, der von den Synchronisiermitteln (91) der Folgen gesteuert wird.

6. Prüfgerät nach Anspruch 5, dadurch gekennzeichnet, daß diese Wiederumlaufmittel einen die Adressenleitungen speisenden Multiplexer (93) einschließen, der einerseits die Daten des Zählers (92) erhält und andererseits die von den Ausgangsleitungen des Speichers über die Verzögerungsleitungen kommenden Daten, wobei die Daten unter der Kontrolle der Synchronisiermittel geschaltet werden.

7. Prüfgerät nach Anspruch 6, dadurch gekennzeichnet, daß diese Synchronisiermittel (91) von einem Taktgeber gebildet werden und mit Blockiermitteln (98) verbunden sind zum Blockieren wenn alle Adressen abgetastet sind, und mit Initialisiermitteln (INI) zum Einleiten der Messfolge.

8. Prüfgerät nach Anspruch 7, dadurch gekennzeichnet, daß die Schreib/Leseauswahlleitung durch die von den Synchronisiermitteln kontrollierten Auswahlmittel gesteuert wird.

9. Prüfgerät nach Anspruch 7 oder 8, dadurch gekennzeichnet, daß diese Auswahlmittel eine Verzögerungsschaltung (96) und einen Impulsgenerator (97) einschließen.

10. Prüfgerät nach Anspruch 9, dadurch gekennzeichnet, daß das Datenschalten im Multiplexer (93) von einer Verzögerungsschaltung (99) gesteuert wird.

**Claims**

1. A method for measuring the Address Access Time (AAT) of a memory including a read/write selection line, a plurality of data output lines, a plurality of data input lines, and a plurality of address lines, characterized by the recirculation of data between n data output lines (do) and n address lines (ad), and that it includes the steps of:

— setting the selection line in the write position,
— loading into the memory a desired configuration of $2^n$ words of n bits corresponding to the $2^n$ addresses, all addresses being scanned, and a word [word (k)] being written in each address.
— setting the selection line into the read position,
— connecting n data output lines (do) to n address lines (ad) through n $\tau$ delay lines (22); since there is a maximum of $m = 2^n$ different words, there is an integer $p \leq m$ such that

$$k = [\text{word (word } (\ldots \text{word } (k) \ldots)]$$

that is, p words, so that the memory oscillates at a frequency such that

$$F = \frac{1}{p(\tau + AAT)}$$

the term ATT representing a mean approximation of the ATTs corresponding to all the address combinations involved in the recirculation process,
— measuring frequency F and determining parameter p, and
— determining the value of the ATT by the relation

$$AAT = \frac{1}{pF} - \tau.$$

2. A method according to claim 1, characterized in that said word configuration is such that, when word [word (k)] is written in address k, and [word (j)] is written in address j, the result is [word (k)]=address j and [word (j)]=address k, so that recirculation is established between the two addresses k and j, thereby deducing

$$ATT = \frac{AAT_{k \to j} + AAT_{j \to k}}{2}$$

3. A method according to claim 1 or 2, characterized in that the memory is a RAM type memory.

4. A tester for the automatic measurement of the ATTs of memories of the type including a read/write selection line, a plurality of data input and output lines, and a plurality of address lines for implementing the method according to claim 1, characterized in it comprises:

— loading means (91—94) for loading the memory (20) according to a desired configuration contained in an auxiliary memory (95) so that a word (word (k)) is written for each address (k) while the selection line is in the write position,

— recirculating means for connecting n data output lines of the memory to n address lines through n $\tau$-delay lines (22) so as to cause recirculation between these addresses while the selection line is in the read position so that the memory oscillates at a frequency F such that

$$F = \frac{1}{p(\tau + ATT)}$$

— synchronization means for synchronizing these operations which are associated with initializing and blocking means for the load and recirculation sequences, and

— measuring means for measuring frequency F.

5. A tester according to claim 4, characterized in that said loading means comprise a multiplexer (94), connected to the data input lines of the memory and also to the auxiliary memory (95) which contains the desired word configuration, and being under the control of a counter (92) controlled by the sequence synchronization means (91).

6. A tester according to claim 5, characterized in that said recirculation means comprise a multiplexer (93) feeding the address lines and receiving the data from the counter (92) and also the data from the memory output lines through the delay lines, switching between these data being under the control of the synchronization means.

7. A tester according to claim 6, characterized in that said synchronization means (91) comprise a clock and are associated with blocking means (98) for blocking when all the addresses are scanned and with initialization means (INI) for starting the measuring sequence.

8. A tester according to claim 7, characterized in that the read/write selection line is controlled by the selection means which are controlled by the synchronization means.

9. A tester according to claim 7 or 8, characterized in that said selection means comprise a delay circuit (96) and a pulse generator (97).

10. A tester according to claim 9, characterized in that data switching in the multiplexer (93) is controlled by a delay circuit (99).

0 020 999

FIG . 1

FIG . 2

FIG . 3

# FIG. 4

# FIG. 5

CONTENU MEMOIRE
DISPONIBLE SUR d.o

**0 020 999**

FIG.6

FIG.7

CHARGEMENT — RECIRCULATION

FIG.8

3

FIG. 9

0 020 999

FIG.10

FIG.13

FIG.11

FIG.12

0 020 999